# EUROPEAN PATENT APPLICATION

(11) **EP 2 104 158 A1**
(43) Date of publication of application: **23.09.2009**
(21) Application number: 09155300.8
(22) Date of filing: 17.03.2009
(51) Int. Cl.: H01L 51/52

(54) **Organic light emitting device**

(30) Priority: 18.03.2008 KR 20080024904
(71) Applicant: Samsung Mobile Display Co., Ltd., Suwon-si Gyeonggi-do (KR)
(72) Inventor: Shin, Hyun-Eok, Gyeonggi-do (KR)
(74) Representative: Gulde Hengelhaupt Ziebig & Schneider

(57) **Abstract**

The present invention relates to an organic light emitting device (100) including an anode electrode (130) having an improved characteristic. The organic light emitting device (100) is constructed with a first electrode (130) including or consiting of indium tungsten oxide (IWO) so that the anode electrode (130) can be readily patterned, an organic light emitting layer (140) formed on the first electrode (130), and a second electrode (150) formed on the organic light emitting layer (140).

## Description

The present invention relates to an organic light emitting device, and more particularly, to an organic light emitting device having an anode that has improved characteristics

### Description of the Related Art

Recently, it is a trend that display apparatuses are replaced by portable and thin flat panel display apparatuses. Among the flat panel display apparatuses, field emission display apparatuses are emissive type display apparatuses that have received considerable attention as the next generation flat display apparatuses due to their large viewing angle, high contrast, and short response time. Organic light emitting devices, in which a light emitting layer is made from an organic material, have high brightness, low driving voltage, short response time, and can be polychrome.

An organic light emitting display apparatus is usually constructed with an organic light emitting device that includes an anode electrode, a cathode electrode, and an intermediate layer disposed between the anode electrode and the cathode electrode. The intermediate layer includes an organic light emitting layer and other organic materials. The organic light emitting device emits visible light by applying a voltage to the organic light emitting layer through electrodes.

In many cases, the anode electrode is made from indium tin oxide (ITO) having a high work function in order to smoothly inject holes into the organic light emitting layer. The anode electrode is formed with a certain pattern by using a wet etching method. The patterning of ITO, however, is not easy since ITO has a very low etching rate. After wet etching, incomplete-etch portions, that is, dim spots, remain in the anode electrode that is made from ITO, thereby, causing electrical failure.

Due to the above reasons, it is not easy to form an anode electrode that has a certain thickness due to the slow etching rate of ITO included in the anode electrode, and also results in many process limitations.

### SUMMARY OF THE INVENTION

It is therefore an object of the present invention to provide an improved organic light emitting device.

It is another object to provide an organic light emitting device having an anode electrode that can be easily patterned, and an organic light emitting display apparatus having the organic light emitting device.

According to an aspect of the present invention, an organic light emitting device is constructed with a first electrode including or consisting of indium tungsten oxide (IWO), an organic light emitting layer formed on the first electrode, and a second electrode formed on the organic light emitting layer.

According to another preferred embodiment of the present invention, the organic light emitting device is constructed with a first electrode including a first layer and a second layer formed on the first layer, the organic light emitting layer formed on the first electrode, and the second electrode formed on the organic light emitting layer. The first layer is formed as a reflection layer to reflect the light generated from the organic light emitting layer. The second layer is interposed between the reflection layer and the organic light emitting layer, and includes or consists of IWO.

According to yet another preferred embodiment of the present invention, the organic light emitting device is constructed with the first electrode including a first layer, a second layer formed on the first layer, and a third layer formed on the second layer, the organic light emitting layer formed on the first electrode, and the second electrode formed on the organic light emitting layer. The first layer includes or consist of IWO. The second layer is formed as a reflection layer on a surface of the first layer that faces the organic light emitting layer to reflect the light generated from the organic light emitting layer. The third layer is interposed between the reflection layer and the organic light emitting layer, and includes or consists of IWO.

The reflection layer may be made from a material selected from a group consisting of Li, Ca, LiF/Al, Al, Mg, and Ag.

The first electrode may be an anode electrode and the second electrode may be a cathode electrode.

An organic light emitting display apparatus may be constructed with a substrate, a plurality of thin film transistors (TFTs) formed on the substrate, an insulating film covering the TFTs and having an opening, a first electrode formed on the insulating film and being electrically connected to the TFTs through the opening, an organic light emitting layer formed on the first electrode, and a second electrode formed on the organic light emitting layer. The first electrode is construed as mentioned before, i.e. includes or consists of IWO.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:

FIG. 1 is a schematic cross-sectional view of an organic light emitting device constructed as an embodiment according to the principles of the present invention;

FIG. 2 is a schematic cross-sectional view of an organic light emitting device constructed as another embodiment according to the principles of the present invention;

FIG. 3 is a magnified cross-sectional view of portion A of FIG. 2;

FIG. 4 is a schematic cross-sectional view of an organic light emitting device constructed as still another embodiment according to the principles of the present invention;

FIG. 5 is a magnified cross-sectional view of portion B of FIG. 4;

FIG. 6 is a schematic cross-sectional view of an active type organic light emitting display apparatus constructed as an embodiment according to the principles of the present invention;

FIG. 7 is a schematic cross-sectional view of an active type organic light emitting display apparatus constructed as another embodiment according to the principles of the present invention;

FIG. 8 is a magnified cross-sectional view of portion C of FIG. 7;

FIG. 9 is a schematic cross-sectional view of an active type organic light emitting display apparatus constructed as still another embodiment according to the principles of the present invention; and

FIG. 10 is a magnified cross-sectional view of portion D of FIG. 9.

### DETAILED DESCRIPTION OF THE INVENTION

The present invention will now be described more fully with reference to the accompanying drawings in which exemplary embodiments of the invention are shown.

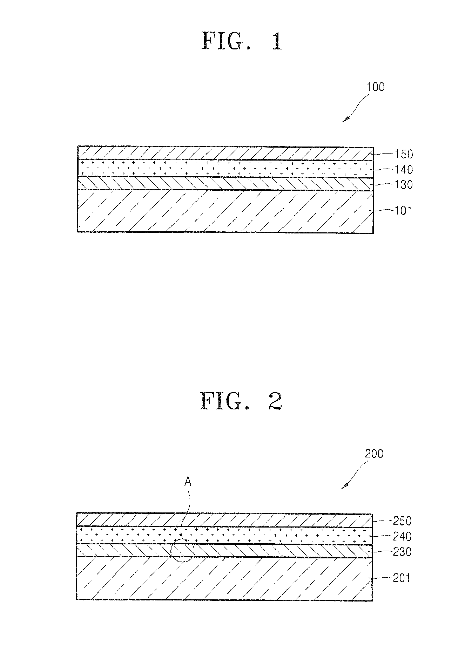

FIG. 1 is a schematic cross-sectional view of an organic light emitting device 100 constructed as an embodiment according to the principles of the present invention. Referring to FIG. 1, organic light emitting device 100 includes a substrate 101, a first electrode 130, an organic light emitting layer 140, and a second electrode 150.

Substrate 101 may be made from a transparent glass material that includes SiO₂ as a main component. Substrate 101, however, is not limited thereto, and may be a plastic substrate made from a transparent plastic material. The plastic substrate may be made from an insulating organic material selected from a group consisting of polyethersulphone (PES), polyacrylate (PAR), polyetherimide (PEI), polyethyelenen napthalate (PEN), polyethyeleneterepthalate (PET), polyphenylene sulfide (PPS), polyallylate, polyimide, polycarbonate (PC), cellulose tri-acetate (TAC), and cellulose acetate propionate (CAP).

If organic light emitting device 100 is a bottom emission type, in which a video image is displayed in a direction from organic light emitting layer 140 toward substrate 101, substrate 101 must be made from a transparent material. If organic light emitting device 100 is a top emission type, in which a video image is displayed in a direction opposite to substrate 101, that is, from organic light emitting layer 140 toward second electrode 150, substrate 101, however, may not necessarily be made from a transparent material, and may be made from a metal. If substrate 101 is made from a metal, the metal may be at least one selected from a group consisting of carbon, iron, chrome, manganese, nickel, titanium, molybdenum, stainless steel (SUS), invar alloy, inconel alloy, and kovar alloy. Substrate 101, however, is not limited thereto, and may be made from a metal foil.

First electrode 130 is formed on substrate 101, and may be formed with a certain pattern using a photolithography method. First electrode 130 includes or preferably is made from indium tungsten oxide (IWO). IWO has a work function similar to that of ITO that is contemporarily used for forming first electrode 130. IWO, however, has an etching rate greater than that of ITO. More specifically, the characteristics of IWO and ITO are summarized in Tables 1 and 2.

**<Table 1>**

| | Work function before treating with UV O₃ | Work function after treating with UV O₃ |
|---|---|---|
| ITO | 4.9eV | 5.4eV |
| IWO | 4.9eV | 5.6eV |

Table 1 summarizes the work functions of IWO and ITO. From Table 1, it can be seen that IWO used for forming first electrode 130 has similar work functions before and after being treated with ozone (UV O₃) when compared to ITO, which is a material used for forming a contemporary first electrode. Thus, when first electrode 130 that includes IWO, is compared to the contemporary first electrode that includes ITO, the charge supply characteristic of first electrode 130 is not reduced.

**<Table 2>**

| | Etching rate (nm/min) |
|---|---|
| ITO | 58 |
| IWO | 122 |

Table 2 summarizes the results of etching IWO and ITO in an acetic acid at a temperature of 40°C. IWO used for forming first electrode 130 has an etching rate twice faster or more than that of ITO.

Consequently, when first electrode 130 is patterned, first electrode 130 may be readily patterned since first electrode 130 includes IWO. That is, IWO has an etching rate twice faster or more than that of ITO used for forming the contemporary first electrode, and thus, first electrode 130 may be readily patterned without affecting other elements.

Organic light emitting layer 140 and second electrode 150 are formed on first electrode 130.

Second electrode 150 may be formed as either a transparent electrode or a reflection electrode. If second electrode 150 is formed as a transparent electrode, second electrode 150 may be formed such that, after depositing Li, Ca, LiF/Ca, LiF/Al, Al, Mg, or a compound of these materials to face an intermediate layer, an auxiliary electrode or a bus electrode line is formed on the metal using a transparent conductive material such as ITO, IZO, ZnO or In₂O₃. If second electrode 150 is formed as a reflection electrode, second electrode 150 may be formed by depositing Li, Ca, LiF/Ca, LiF/Al, Al, Mg, or a compound of these materials.

Organic light emitting layer 140 interposed between first electrode 130 and second electrode 150 emits light due to the driving of first electrode 130 and second electrode 150. Organic light emitting layer 140 may be made from either a low molecular weight organic material or a polymer organic material. If organic light emitting layer 140 is made from a low molecular weight organic material, a hole transport layer (not shown) and a hole injection layer (not shown) are stacked in a direction towards first electrode 130, from organic light emitting layer 140, and an electron transport layer (not shown) and an electron injection layer (not shown) are stacked in a direction towards second electrode 150, from organic light emitting layer 140.

Besides the above layers, various layers may be stacked as necessary. Organic materials that may be used for forming organic light emitting layer 140 include copper phthalocyanine (CuPc), N,N'-Di(naphthalene-1-yl)-N,N'-diphenyl-benzidine (NPB), and tris-8-hydroxyquinoline aluminum (Alq3), and the present invention is not limited thereto.

If organic light emitting layer 140 is made from a polymer organic material, only a hole transport layer (HTL) (not shown) may be included in a direction towards first electrode 130, from organic light emitting layer 140. That is, the polymer hole transport layer is formed on first electrode 130 using poly-(2,4)-ethylene-dihydroxy thiophene (PEDOT) or polyaniline (PANI) by an inkjet printing method or a spin coating method. Qrganic light emitting layer 140 may be formed in a color pattern using a material such as poly-phenylenevinylene (PPV), soluble PPV's, cyano-PPV, or polyfluorene by using a contemporary inkjet printing method, a spin coating method, or a thermal transfer using a laser.

In organic light emitting device 100 according to the present embodiment, first electrode 130 includes IWO that has an etching rate twice faster or more than that of ITO. If the etching rate is high, the time required to form a pattern is reduced. If the etching time is long, elements that do not need to be etched are affected by an etching solution, and thus, it is difficult to obtain a desired pattern.

If a material has a low etching rate like ITO, incomplete-etch portions may occur after an etching process. Such etch-failure causes an undesired pattern, and thus, dim spots remain in an anode electrode that includes ITO, thereby, causing electrical failure.

First electrode 130 according to the present embodiment, however, includes IWO that has high etching rate, and thus, an etching time may be reduced and a desired pattern may be readily formed, thereby preventing an electrical failure. Also, IWO used to form first electrode 130 has a work function as high as ITO, and thus, IWO may act as an anode electrode that injects holes into organic light emitting layer 140.

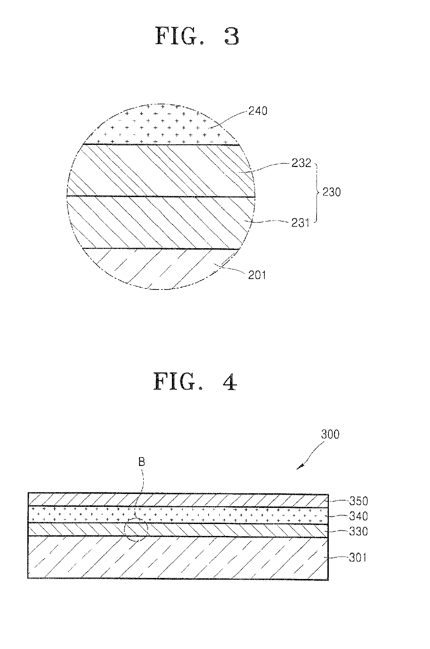

FIG. 2 is schematic a cross-sectional view of an organic light emitting device 200 constructed as another embodiment according to the principles of the present invention. FIG. 3 is a magnified cross-sectional view of portion A of FIG. 2.

Organic light emitting device 200 includes a substrate 201, a first electrode 230, an organic light emitting layer 240, and a second electrode 250. Organic light emitting device 200 according to the current embodiment has a similar structure as organic light emitting device 100 of FIG. 1. First electrode 230, however, has a structure different from first electrode 130 of FIG. 1, and thus, for convenience of explanation, the difference will be mainly described.

First electrode 230 includes a first layer 231 and a second layer 232. Referring to FIG. 3, first layer 231 of first electrode 230 is formed on substrate 201, second layer 232 is formed on first layer 231, and organic light emitting layer 240 is formed on second layer 232.

First layer 231 is a reflection layer, and may be made from Li, Ca, LiF/Ca, LiF/Al, Al, or Mg. Second layer 232 is made from IWO. First layer 231 includes a metal having a high reflectance to function as a reflective layer. Light generated from organic light emitting layer 240 is reflected by first layer 231 and is emitted in a direction towards second electrode 250. That is, organic light emitting device 200 according to the present embodiment has a top emissive type structure.

Since second layer 232 that contacts organic light emitting layer 240 includes or preferably consists of IWO, second layer 232 has a work function similar to that of ITO, and thus, may function as an anode electrode.

IWO has an etching rate twice faster or more than that of the ITO. In the prior art, if second layer 232 is made from ITO, the patterning of first electrode 230 using a wet etching process is not easy due to the etching rate difference between first layer 231 and second layer 232.

The ITO has a significantly low etching rate as compared to a metal such as Ag. Thus, in the prior art, in order to pattern first electrode 230, the etching time is determined according to the etching time of ITO. Since the etching time is set according to the etching rate of ITO, first layer 231 of first electrode 230 is etched to a desired pattern earlier than the etching of second layer 232 is completed. As a result, when the etching of first electrode 230 is completed, first layer 231 is over-etched to result in an undesirable pattern or etching particles.

If the etching time is reduced to prevent first layer 231 from over-etching, second layer 232 that includes ITO may be incompletely etched, and thus, a desired pattern may not be obtained. Due to the above reason, the patterning of first electrode 230 is not easy in the prior art.

Second layer 232 of first electrode 230 according to present embodiment, however, includes IWO that does not affect the electrical characteristics of first electrode 230 since IWO has a work function similar to that of ITO. Also, patterning of first electrode 230 is easy since IWO has an etching rate twice faster or more than that of ITO. As a result, an organic light emitting device having significantly reduced electrical failures can be manufactured.

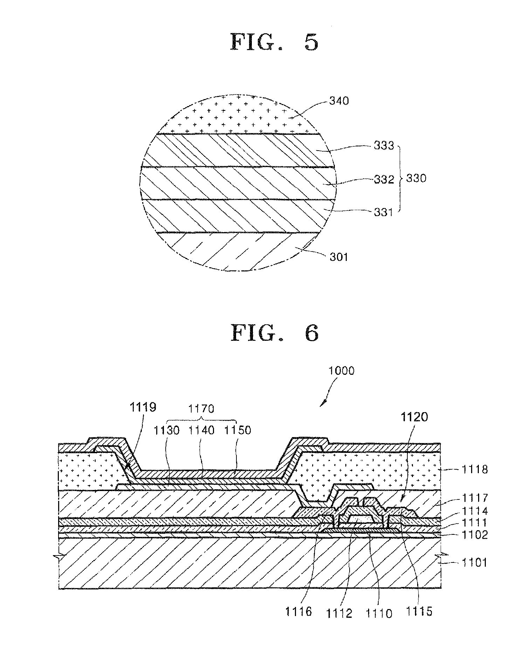

FIG. 4 is a schematic cross-sectional view of an organic light emitting device 300 constructed as another embodiment according to the principles of the present invention. FIG. 5 is a magnified cross-sectional view of portion B of FIG. 4.

Organic light emitting device 300 is constructed with a substrate 301, a first electrode 330, an organic light emitting layer 340, and a second electrode 350. Organic light emitting device 300 according to the current embodiment has a similar structure as organic light emitting device 100 of FIG. 1. First electrode 330 of organic light emitting device 300, however, has a structure different from first electrode 130 of FIG. 1, and thus, for convenience of explanation, the difference will be mainly described.

First electrode 330 is constructed with a first layer 331, a second layer 332, and a third layer 333. Referring to FIG. 5, first layer 331 of first electrode 330 is formed on substrate 301, second layer 332 is formed on first layer 331, third layer 333 is formed on second layer 332, and organic light emitting layer 340 is formed on third layer 333.

First layer 331 includes or preferably is made from IWO. Since IWO has a high adhesion force with other elements, IWO may increase an adhesion force between first electrode 330 and substrate 301.

Second layer 332 is formed as a reflection layer, and may be made from Li, Ca, LiF/Al, Al, Mg, or Ag. Second layer 332 is made from a metal having a high reflectance to function as a reflection layer. Light generated from organic light emitting layer 340 is reflected by second layer 332 and is emitted in a direction towards second electrode 350. That is, organic light emitting device 300 according to present embodiment has a top emissive type structure.

Third layer 333 that contacts organic light emitting layer 340 includes or preferably consists of IWO. Since IWO has a work function similar to that of ITO, first electrode 330 may function as an anode electrode.

IWO has an etching rate twice faster or more than that of ITO. Thus, first layer 331 and third layer 333 of first electrode 330 may be readily etched as compared to etching contemporary first and third layers 331 and 333 made from ITO. As a result, an organic light emitting device having significantly reduced electrical failures can be manufactured.

An organic light emitting display apparatus can be manufactured using the organic light emitting device according to the principles of the present invention. The organic light emitting display apparatus may be either passive matrix type (PM type) or active matrix type (AM type). In the present embodiments, for convenience of explanation, an AM type structure is described; however, the present invention can also be applied to the PM type structure.

FIG. 6 is a schematic cross-sectional view of an active type organic light emitting display apparatus 1000. Referring to FIG. 6, active type organic light emitting display apparatus 1000 is constructed with a substrate 1101, a thin film transistor (TFT) 1120, a passivation film 1117, and an organic light emitting device 1170. Organic light emitting device 1170 is constructed with a first electrode 1130, an organic light emitting layer 1140, and a second electrode 1150.

Referring to FIG. 6, TFT 1120 is formed on a top surface of substrate 1101. At least one TFT is formed in each of pixels and is electrically connected to organic light emitting device 1170.

Substrate 1101 may be made from a transparent material that includes SiO₂ as a main component. Substrate 1101, however, is not limited thereto, and may be a plastic substrate made from a transparent plastic material. The plastic substrate may be made from an insulating organic material selected from a group consisting of polyethersulphone (PES), polyacrylate (PAR), polyetherimide (PEI), polyethyelenen napthalate (PEN), polyethyeleneterepthalate (PET), polyphenylene sulfide (PPS), polyallylate, polyimide, polycarbonate (PC), cellulose tri-acetate (TAC), and cellulose acetate propionate (CAP).

If organic light emitting device 1170 is a bottom emission type, in which a video image is displayed in a direction from light emitting device 1170 toward substrate 1101, substrate 1101 must be made from a transparent material. If organic light emitting device 1170 is a top emission type, in which an image is displayed in a direction opposite to substrate 1101, that is, in a direction from light emitting layer 1140 toward second electrode 1150, substrate 1101 may not necessarily be made from a transparent material, and may be made from a metal. If substrate 1101 is made from a metal, the metal may be at least one selected from a group consisting of carbon, iron, chrome, manganese, nickel, titanium, molybdenum, stainless steel (SUS), invar alloy, inconel alloy, and kovar alloy. Substrate 1101, however, is not limited thereto, and may be made from a metal foil.

A buffer layer 1102 may be formed on the top surface of substrate 1101 in order to provide the planarity of substrate 1101 and to block the penetration of impurity elements of SiO₂ or/and SiNx.

More specifically, a semiconductor layer 1110 having a certain pattern is formed on buffer layer 1102. Semiconductor layer 1110 may be made from an inorganic semiconductor material such as amorphous silicon or poly silicon, and may be constructed with a source region, a drain region, and a channel region.

A gate insulating film 1111 is formed on semiconductor layer 1110 using SiO₂ or SiNx. Gate insulating film 1111 may be made from an inorganic material such as a metal oxide or a metal nitride, or may be made from an organic material such as an insulating polymer.

A gate electrode 1112 is formed on a certain region of gate insulating film 1111. Gate electrode 1112 is connected to a gate line (not shown) that applies an ON/OFF signal for TFT 1120. Gate electrode 1112 may be made from a metal such as Au, Ag, Cu, Ni, Pt, Pd, Al, or Mo, or a metal alloy such as Al:Nd or Mo:W.

An interlayer insulating layer 1114 is formed on gate electrode 1112, and a source electrode 1115 and a drain electrode 1116 are formed to contact the source and drain regions, respectively, through contact holes. Source electrode 1115 and drain electrode 1116 may be made from a material such as Au, Pd, Pt, Ni, Rh, Ru, Ir, or Os, and also, may be made from Al or Mo, or an alloy made from at least two metals such as an Al:Nd alloy or a MoW alloy.

TFT 1120 formed in this way is covered by passivation film 1117 to protect TFT 1120. Passivation film 1117 may be formed as either an inorganic insulating film or an organic insulating film. The inorganic insulating film may be made from SiO₂, SiNx, SiON, Al₂O₃, TiO₂, Ta₂O₅, HfO₂, ZrO₂, BST, or PZT, and the organic insulating film may be made from a general-use polymer such as PMMA or PS, a polymer derivative having a phenol group, an acryl group polymer, an imide group polymer, an ester group polymer, an amide group polymer, a fluorine group polymer, a p-xylene group polymer, a vinyl alcohol group polymer, or a blend of these polymers. Alternatively, passivation film 1117 may be formed in a complex stack including layers of the inorganic insulating film and the organic insulating film.

First electrode 1130, which will be an anode electrode, is formed on passivation film 1117. A pixel defining layer 1118 is formed to cover first electrode 1130 and is made from an insulating material. After forming an opening 1119 in pixel defining layer 1118, organic light emitting layer 1140 is formed in a region defined by opening 1119. Afterwards, second electrode 1150, which is a cathode electrode, is formed to cover the entire pixels.

First electrode 1130 may be patterned to a certain pattern using a photolithography method. Second electrode 1150 is disposed on first electrode 1130, and can be used as a cathode electrode by being connected to an external terminal (not shown). In the case of the AM type organic light emitting display apparatus, first electrode 1130 may be formed on an entire active region on which an image is displayed.

First electrode 1130 includes or preferably is made from IWO that has a work function similar to that of ITO, which is mainly used for forming a contemporary first electrode. Thus, first electrode 1130 that is made from IWO according to the present embodiment, has a charge supply characteristic equivalent to that of a contemporary first electrode that is made from ITO.

Also, IWO has an etching rate twice faster or more than that of ITO. Thus, when first electrode 1130 is patterned, first electrode 1130 according to the present embodiment may be readily patterned since first electrode 1130 includes IWO. That is, IWO has an etching rate twice faster or more than that of ITO, which is used for forming the contemporary first electrode, and thus, first electrode 1130 can be readily patterned without affecting other elements in active type organic light emitting display apparatus 1000.

Second electrode 1150 may be formed as either a transparent electrode or a reflection electrode. If second electrode 1150 is formed as a transparent electrode, second electrode 1150 may be formed such that, after depositing a metal such as Li, Ca, LiF/Ca, LiF/Al, Al, Mg, or a compound of these materials to face an intermediate layer, an auxiliary electrode or a bus electrode line is formed on the metal using a transparent conductive material such as ITO, IZO, ZnO or In₂O₃. If second electrode 150 is formed as a reflection electrode, second electrode 1150 may be formed by depositing Li, Ca, LiF/Ca, LiF/Al, Al, Mg, or a compound of these materials.

Organic light emitting layer 1140 interposed between first electrode 1130 and second electrode 1150 emits light due to the electrical driving of first electrode 1130 and second electrode 1150. Organic light emitting layer 1140 may be made from either a low molecular weight organic material or a polymer organic material. If organic light emitting layer 1140 is made from a low molecular weight organic material, a hole transport layer (not shown) and a hole injection layer (not shown) are stacked in a direction towards first electrode 1130, from organic light emitting layer 1140, and an electron transport layer (not shown) and an electron injection layer (not shown) are stacked in a direction towards second electrode 1150, from organic light emitting layer 1140.

Besides the above layers, various layers may be stacked as necessary. Organic materials that may be used for forming organic light emitting layer 1140 includes copper phthalocyanine (CuPc), N,N'-Di(naphthalene-1-yl)-N,N'-diphenyl-benzidine (NPB), and tris-8-hydroxyquinoline aluminum (Alq3), and the present invention is not limited thereto.

In the case of a polymer organic layer made from a polymer organic material, only a hole transport layer (HTL) (not shown) may be included in a direction towards first electrode 1130, from organic light emitting layer 1140. That is, the polymer hole transport layer (HTL) is formed on first electrode 1130 using poly-(2,4)-ethylene-dihydroxy thiophene (PEDOT) or polyaniline (PANI) by an inkjet printing method or a spin coating method. Organic light emitting layer 1140 may be formed in a color pattern using a material such as poly-phenylenevinylene (PPV), soluble PPV's, cyano-PPV, or polyfluorene by using a contemporary inkjet printing method, a spin coating method, or a thermal transfer using a laser.

A sealing member (not shown) that seals organic light emitting device 1170 is formed on organic light emitting device 1170. The sealing member is formed to protect organic light emitting device 1170 from external moisture or oxygen. In a top emissive type organic light emitting display apparatus, the sealing member is made from a transparent material. For this purpose, the sealing member may be a glass substrate, a plastic substrate, or a plurality of overlapped structures of an organic material and an inorganic material.

In active type organic light emitting display apparatus 1000 according to the present embodiment, first electrode 1130 is made from IWO that has an etching rate twice faster or more than that of ITO. If the etching rate is high, the time required to form a desired pattern is reduced.

First electrode 1130 may be readily etched since the etching rate of first electrode 1130 is high, and thus, a desired pattern may be readily formed. Accordingly, the formation of incomplete-etch portions may be prevented, thereby preventing an electrical failure. Also, IWO used to form first electrode 1130 has a high work function similar to that of ITO, and thus, first electrode 1130 may act as an anode electrode that injects holes into organic light emitting layer 1140.

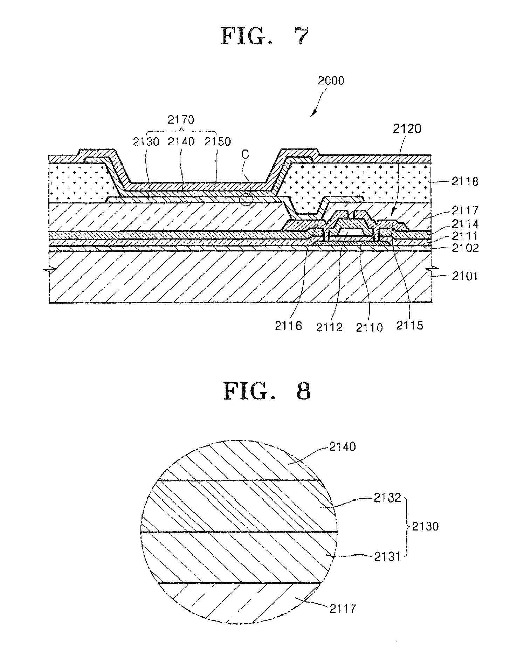

FIG. 7 is a schematic cross-sectional view of an active type organic light emitting display apparatus 2000 constructed as another embodiment according to the principles of the present invention. FIG. 8 is a magnified cross-sectional view of portion C of FIG. 7.

Active type organic light emitting display apparatus 2000 is constructed with a substrate 2101, a TFT 2120, a passivation film 2117, and an organic light emitting device 2170. Organic light emitting device 2170 is constructed with a first electrode 2130, and organic light emitting layer 2140, and a second electrode 2150.

Active type organic light emitting display apparatus 2000 according to the present embodiment has a structure similar to active type organic light emitting display apparatus 1000 shown in FIG. 6; however, first electrode 2130 of active type organic light emitting display apparatus 2000 has a structure different from first electrode 1130 of active type organic light emitting display apparatus 1000 shown in FIG. 6. Substrate 2101 and TFT 2120 under first electrode 2130 are similar to substrate 1101 and TFT 1120 of FIG. 6, and thus, the descriptions thereof will not be repeated, and, for convenience of explanation, the differences from the foregoing embodiment will be mainly described.

First electrode 2130 is constructed with a first layer 2131 and a second layer 2132. Referring to FIG. 8, first layer 2131 of first electrode 2130 is formed on passivation film 2117, second layer 2132 is formed on first layer 2131, and organic light emitting layer 2140 is formed on second layer 2132.

First layer 2131 is a reflection layer, and may be made from Li, Ca, LiF/Ca, LiF/Al, Al, or Mg. Second layer 2132 is made from IWO. First layer 2131 is made from a metal having a high reflectance so as to function as a reflective layer. Light generated from organic light emitting layer 2140 is reflected by first layer 2131 and is emitted in a direction towards second electrode 2150. That is, active type organic light emitting device 2000 according to the present embodiment has a top emissive type structure.

Since second layer 2132 that contacts organic light emitting layer 2140 includes IWO, second layer 2132 has a work function similar to that of ITO, and thus, may function as an anode electrode.

IWO has an etching rate twice faster or more than that of ITO. In the prior art, if second layer 2132 is made from ITO, the patterning of first electrode 2130 using a wet etching process is not easy due to the etching rate difference between first layer 2131 and second layer 2132.

ITO has a significantly slow etching rate as compared to a metal such as Ag. Thus, in the prior art, in order to pattern first electrode 2130, the etching time is determined according to the etching time of ITO. Since the etching time is set according to the etching rate of ITO, first layer 2131 of first electrode 2130 is etched to a desired pattern earlier than the etching of second layer 232 is completed. As a result, when the etching of first electrode 2130 is completed, first layer 2131 is over-etched to result in an undesired pattern or etching particles.

If the etching time is reduced to prevent first layer 2131 from over-etching, second layer 2132 that includes ITO may be incompletely etched, and thus, a desired pattern may not be obtained. Due to the above reason, the patterning of first electrode 2130 is not easy in the prior art.

Second layer 2132 of first electrode 2130 according to the present embodiment, however, includes IWO that does not affect the electrical characteristics of first electrode 2130, since IWO has a work function similar to that of ITO. Also, patterning of first electrode 2130 is easy since IWO has an etching rate twice faster or more than that of ITO. As a result, an organic light emitting device having significantly reduced electrical failures can be manufactured.

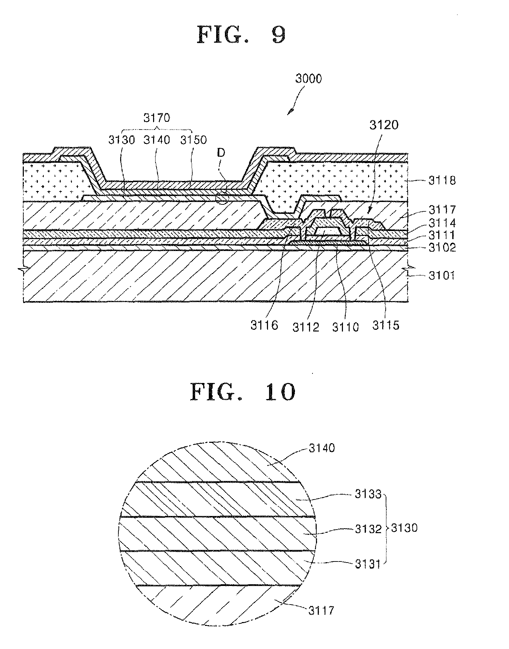

FIG. 9 is a schematic cross-sectional view of an active type organic light emitting display apparatus 3000 constructed as another embodiment according to the principles of the present invention. FIG. 10 is a magnified cross-sectional view of portion D of FIG. 9.

Active type organic light emitting display apparatus 3000 is constructed with a substrate 3101, a TFT 3120, a passivation film 3117, and an organic light emitting device 3170. Organic light emitting device 3170 is constructed with a first electrode 3130, and organic light emitting layer 3140, and a second electrode 3150.

Substrate 3101 under first electrode 3130 and TFT 3120 are similar to substrate 2101 and TFT 2120 of the previous embodiment, and thus, the descriptions thereof will not be repeated. For convenience of explanation, the differences from the foregoing embodiment will be mainly described.

First electrode 3130 is constructed with a first layer 3131, a second layer 3132, and a third layer 3133. Referring to FIG. 10, first layer 3131 of first electrode 3130 is formed on passivation film 3117, second layer 3132 is formed on first layer 3131, third layer 3133 is formed on second layer 3132, and organic light emitting layer 3140 is formed on third layer 3133.

First layer 3131 is constructed with IWO. Since IWO has a high adhesion force with other elements, IWO may increase an adhesion force between first electrode 3130 and passivation film 3117. As described above, passivation film 3117 protects and insulates TFT 3120 by covering TFT 3120, and, in order to do so, passivation film 3117 may be either an organic insulating film or an inorganic insulating film. IWO has a high adhesion force as compared to a metal. An adhesion force between first electrode 3130 and passivation film 3117 may be increased by forming first layer 3131 using IWO, which is a portion of first electrode 3130 that contacts passivation film 3117.

Second layer 3132 is formed as a reflection layer, and may be made from Li, Ca, LiF/Al, Al, Mg, or Ag. Second layer 3132 is made from a metal having a high reflectance to function as a reflection layer. Light generated from organic light emitting layer 3140 is reflected by second layer 3132 and is emitted in a direction towards second electrode 3150. That is, active type organic light emitting device 3000 according to the present embodiment has a top emissive type structure.

Third layer 3133 that contacts organic light emitting layer 3140 includes IWO. Since IWO has a work function similar to that of ITO, first electrode 3130 may function as an anode electrode.

IWO has an etching rate twice faster or more than that of ITO. Thus, first layer 3131 and third layer 3133 of first electrode 3130 may be readily etched as compared to the contemporary first and third layers made from ITO. As a result, an organic light emitting device having significantly reduced electrical failures can be manufactured.
An organic light emitting device and an organic light emitting display apparatus according to the principles of the present invention include an anode electrode having improved characteristics. Thus, the anode electrode can be readily patterned, and thus, electrical failure of the organic light emitting device can be reduced.

## Claims

1. An organic light emitting device (100, 200, 300) comprising:
a first electrode (130, 230, 330) comprising or consisting of indium tungsten oxide (IWO);
an organic light emitting layer (140, 240, 340) formed on the first electrode (130, 230, 330); and
a second electrode (150, 250) formed on the organic light emitting layer (140, 240).

2. The organic light emitting device of claim 1, comprised of the first electrode (130, 230, 330) being an anode electrode and the second electrode (150) being a cathode electrode.

3. The organic light emitting device of claim 1 or 2, comprised of the first electrode (230) comprising a first layer (231) and a second layer (232) formed on the first layer (231), with:
the first layer (231) being formed as a reflection layer to reflect the light generated from the organic light emitting layer (240); and
the second layer (232) being interposed between the reflection layer and the organic light emitting layer (240), and comprising or consisting of indium tungsten oxide (IWO).

4. The organic light emitting device of claim 1 or 2, comprised of the first electrode (330) comprises a first layer (331), a second layer (332) formed on the first layer (331), and a third layer (333) formed on the second layer (332), with:
the first layer (331) comprising or consisting of Indium tungsten oxide (IWO);
the second layer (332) being formed as a reflection layer, and on a surface of the first layer (331) that faces the organic light emitting layer (340) so as to reflect the light generated from the organic light emitting layer (340); and
the third layer (333) being interposed between the reflection layer and the organic light emitting layer (340), and comprising or consisting of Indium tungsten oxide (IWO).

5. The organic light emitting device of claim 3 or 4, comprised of the reflective layer being made from a material selected from a group consisting of Li, Ca, LiF/Al, Al, Mg, and Ag.
